# EUROPEAN PATENT SPECIFICATION

(11) **EP 2 530 728 B1**
(45) Date of publication and mention of the grant of the patent: **31.01.2018**
(21) Application number: 11736991.8
(22) Date of filing: 25.01.2011
(51) Int. Cl.: H01L 31/0749, H01L 31/04, H01L 31/046

(54) **METHOD FOR MANUFACTURING A SEMICONDUCTOR LAYER, METHOD FOR MANUFACTURING A PHOTOELECTRIC CONVERSION DEVICE, AND A SEMICONDUCTOR LAYER FORMING SOLUTION**
VERFAHREN ZUR HERSTELLUNG EINER HALBLEITERSCHICHT, VERFAHREN ZUR HERSTELLUNG EINER PHOTOELEKTRISCHEN UMWANDLUNGSVORRICHTUNG SOWIE LÖSUNG ZUR HERSTELLUNG EINER HALBLEITERSCHICHT
PROCÉDÉ DE FABRICATION D'UNE COUCHE SEMICONDUCTRICE, PROCÉDÉ DE FABRICATION D'UN DISPOSITIF DE CONVERSION PHOTOÉLECTRIQUE ET SOLUTION DE FORMATION D'UNE COUCHE SEMICONDUCTRICE

(30) Priority: 29.01.2010 JP 2010018922; 29.01.2010 JP 2010018796; 29.01.2010 JP 2010018999; 29.01.2010 JP 2010018998
(43) Date of publication of application: 05.12.2012
(73) Proprietor: Kyocera Corporation, Kyoto-shi, Kyoto 612-8501 (JP)
(72) Inventor: OGURI, Seiji, Higashiomi-shi Shiga 527-8555 (JP); TAKEDA, Keizo, Higashiomi-shi Shiga 527-8555 (JP); YAMADA, Koichiro, Higashiomi-shi Shiga 527-8555 (JP); TANIGAWA, Kotaro, Higashiomi-shi Shiga 527-8555 (JP); TANAKA, Isamu, Higashiomi-shi Shiga 527-8555 (JP); SASAMORI, Riichi, Higashiomi-shi Shiga 527-8555 (JP); OGAWA, Hiromitsu, Higashiomi-shi Shiga 527-8555 (JP)
(74) Representative: Viering, Jentschura & Partner mbB Patent- und Rechtsanwälte
(86) International application number: PCT/JP2011/051332
(87) International publication number: WO 2011/093278

(56) References cited:
- JP-A- 2002 501 003
- JP-A- 2008 192 542
- US-B1- 6 992 202
- US-B1- 6 992 202
- WANG Y H A ET AL: "Synthesis of ternary and quaternary CuInxGa1-xSe2 (0@?x@?1) semiconductor nanocrystals", SOLID STATE SCIENCES, ELSEVIER, PARIS, FR, vol. 11, no. 11, 1 November 2009 (2009-11-01), pages 1961-1964, XP026710450, ISSN: 1293-2558, DOI: 10.1016/J.SOLIDSTATESCIENCES.2009.07.005 [retrieved on 2009-07-15]
- K.K. BANGER ET AL.: 'Facile modulation of single source precursors: the synthesis and characterization of single source precursors for deposition of ternary chalcopyrite materials' THIN SOLID FILMS vol. 403-404, 01 February 2001, pages 390 - 395, XP004430390

## Description

### TECHNICAL FIELD

The present invention relates to a method for manufacturing a semiconductor layer containing a group 11-13-16 compound, a method for manufacturing a photoelectric conversion device using the same, and a semiconductor layer forming solution.

### BACKGROUND ART

As a solar cell, there is the one using a photoelectric conversion device that includes a light-absorbing layer containing a chalcopyrite-based, for example, CIGS-based, group 11-13-16 compound. Such a photoelectric conversion device comprises a substrate including soda-lime glass. On the substrate, a first electrode layer containing, for example, Mo and serving as a back surface electrode is formed. On the first electrode layer, a first semiconductor layer containing a group 11-13-16 compound is formed as a light-absorbing layer. Moreover, on the first semiconductor layer, a second semiconductor layer comprised of a material selected from ZnS, CdS, and the like, is formed as a buffer layer. Furthermore, on the second semiconductor layer, a transparent second electrode layer containing ZnO or the like is formed.

As a manufacturing method for forming such a first semiconductor layer, the following method is disclosed.

Specification of United States Patent No. 6992202 discloses forming a Cu(In,Ga)Se₂ semiconductor layer by using a single source precursor that is a compound in which Cu, Se, and In or Ga exist in one organic compound.

However, in the manufacturing method using the single source precursor mentioned above, it is difficult to control a composition of the first semiconductor layer, that is, the molar ratio of Cu/(In+Ga), and there is a limit to the improvement in energy conversion efficiency. Therefore, further improvement in the energy conversion efficiency has been demanded in the photoelectric conversion device.

Wang et al.: "Synthesis of ternary and quaternary CuInxGa1-xSe2 (0≤x≤1) semiconductor nanocrystals", Solid State Sciences, Elsevier, Paris, FR, vol. 11, no. 11, 1 November 2009 (2009-11-01), pages 1961-1964 discloses the synthesis of both cubic and spherical CuInₓGa₁₋ₓSe₂ semiconductor nanocrystals across the whole composition range via a simple solution-based route involving the thermal decomposition and reaction of metal-acetylacetonate precursors with selenium-oleylamine.

### SUMMARY OF THE INVENTION

One embodiment of the present invention aims at forming a semiconductor layer with a desired composition ratio to thereby provide a photoelectric conversion device having a high energy conversion efficiency.

The present invention provides a method for manufacturing a semiconductor layer as defined in claim 1, and a method for manufacturing a photoelectric conversion device as defined in claim 8.

Further embodiments of the method for manufacturing a semiconductor layer are described in dependent claims 2 to 7.

The present invention further provides a semiconductor layer forming solution as defined in claim 9.

### BRIEF DESCRIPTION OF THE DRAWINGS

FIG. 1 is a perspective view showing an example of an embodiment of a photoelectric conversion device.
FIG. 2 is a cross-sectional view of the photoelectric conversion device of FIG. 1.

### EMBODIMENT FOR CARRYING OUT THE INVENTION

Hereinafter, a method for manufacturing a semiconductor layer, a method for manufacturing a photoelectric conversion device, and a semiconductor forming solution according to an embodiment of the present invention will be described in detail with reference to the drawings.

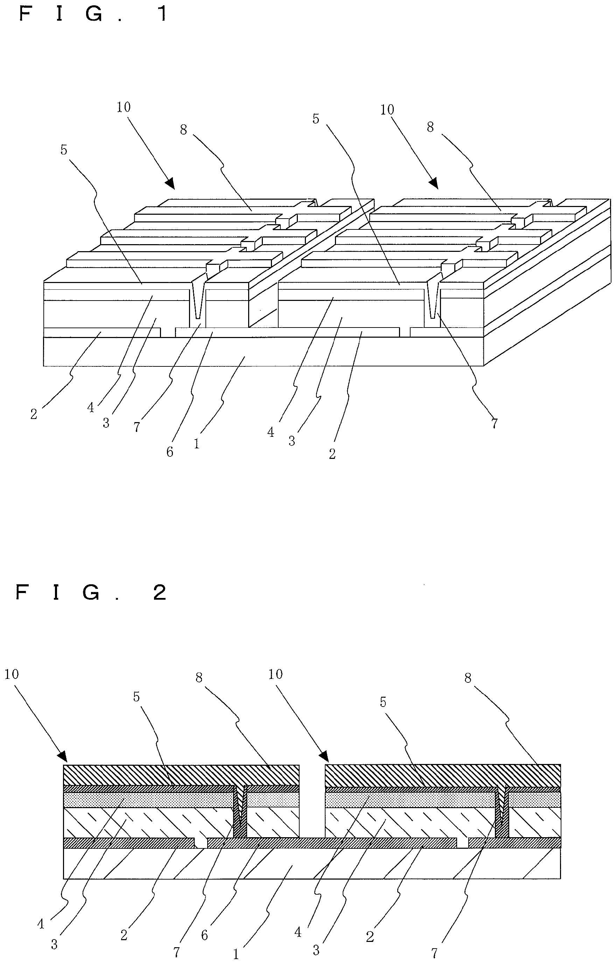

FIG. 1 is a perspective view showing an example of a photoelectric conversion device made by the method for manufacturing the semiconductor layer according to the embodiment of the present invention. FIG. 2 is a cross-sectional view thereof. A photoelectric conversion device 10 includes a substrate 1, a first electrode layer 2, a first semiconductor layer 3 that is a semiconductor layer containing a group 11-13-16 compound, a second semiconductor layer 4, and a second electrode layer 5. This is not limitative, and the second semiconductor layer 4 may be a semiconductor layer containing a group 11-13-16 compound.

The first semiconductor layer 3 and the second semiconductor layer 4 have different conductive types, and they are electrically connected. Thereby, a photoelectric conversion body capable of successfully extracting charges is provided. For example, when the first semiconductor layer 3 is of p-type, the second semiconductor layer 4 is of n-type. A high-resistance buffer layer may be interposed between the first semiconductor layer 3 and the second semiconductor layer 4. In an example shown in this embodiment, the first semiconductor layer 3 serves as a light-absorbing layer of one conductive type, and the second semiconductor layer 4 serves as both a buffer layer and a semiconductor layer of the other conductive type.

In the photoelectric conversion device 10 of this embodiment, it is assumed that a light is incident from the second electrode layer 5 side. However, this is not limitative, and a light may be incident from the substrate 1 side.

In FIGS. 1 and 2, a plurality of the photoelectric conversion devices 10 are arranged. The photoelectric conversion device 10 includes, at the substrate 1 side of the first semiconductor layer 3, a third electrode layer 6 that is spaced from the first electrode layer 2. A connecting conductor 7 provided in the first semiconductor layer 3 electrically connects the second electrode layer 5 and the third electrode layer 6 to each other. In FIGS. 1 and 2, the third electrode layer 6 is formed by extension of the first electrode layer 2 of the adjacent photoelectric conversion device 10. Thus, in this configuration, the adjacent photoelectric conversion devices 10 are connected in series with one another. In one photoelectric conversion device 10, the connecting conductor 7 is provided so as to penetrate through the first semiconductor layer 3 and the second semiconductor layer 4. The first semiconductor layer 3 and the second semiconductor layer 4 that are sandwiched between the first electrode layer 2 and the second electrode layer 5 perform photoelectric conversion.

The substrate 1 is for supporting the photoelectric conversion device 10. Examples of a material for the substrate 1 include glass, ceramic, resins, and metals.

For the first electrode layer 2 and the third electrode layer 6, a conductive material such as Mo, Al, Ti, or Au is used, and they are formed on the substrate 1 by a sputtering process, a vapor-deposition process, or the like.

The first semiconductor layer 3 contains a group 11-13-16 compound (herein also called a "I-III-VI group compound"). The group 11-13-16 compound means a compound of a group 11 element (herein also called a "I-B group element"), a group 13 element (herein also called a "III-B group element"), and a group 16 element (herein also called a "VI-B group element"). The group 11-13-16 compound includes a chalcopyrite structure, and is called a chalcopyrite-based compound (also called as a CIS-based compound). Examples of the group 11-13-16 compound include Cu(In,Ga)Se₂ (also called CIGS), Cu(In,Ga)(Se,S)₂ (also called CIGSS), and CuInSe₂ (also called CIS), Cu(In,Ga)Se₂ means a compound mainly containing Cu, In, Ga, and Se. Cu(In,Ga)(Se,S)₂ means a compound mainly containing Cu, In, Ga, Se, and S. Such a group 11-13-16 compound has a high photoelectric conversion efficiency, and provides an effective electromotive force when used as a thin layer of 10 µm or less.

This first semiconductor layer 3 is made as follows. Firstly, a semiconductor layer forming solution for forming the first semiconductor layer 3 is prepared. Then, by using the semiconductor layer forming solution, a coating is formed. This coating is subjected to a heat treatment, thereby forming the first semiconductor layer 3. Such a semiconductor layer forming solution is made by a step of preparing a first compound, a step of preparing a second compound, and a step of making a semiconductor layer forming solution. In the following, each of the steps will be described in detail.

### <<Step of Preparing First Compound>>

In the first compound, a first chalcogen-element-containing organic compound, a first Lewis base, a group 11 element, and a first group 13 element are contained in one complex molecule. That is, the first compound contains all of the group 11 element, the group 13 element, and the group 16 element that are elements constituting the group 11-13-16 compound. The group 11-13-16 compound can be formed through a chemical reaction of these elements. Accordingly, the first compound may be called a single source precursor. Hereinafter, the first compound will be also referred to as a single source precursor.

The chalcogen-element-containing organic compound is an organic compound including a chalcogen element (the chalcogen element means S, Se, Te among the group 16 elements). Examples thereof include thiol, sulfide, disulfide, thiophene, sulfoxide, sulfone, thioketone, sulfonic acid, sulfonic acid ester, sulfonic acid amide, selenol, selenide, diselenide, selenoxide, selenone, tellurol, telluride, and ditelluride. Particularly, from the viewpoint of having high coordinating power that makes it easy to form a stable complex with a metal element, thiol, sulfide, disulfide, selenol, selenide, diselenide, tellurol, telluride, or ditelluride may be adopted.

The Lewis base is a compound including an unshared pair of electrons. As the Lewis base, an organic compound compring a functional group provided with a group 15 element (herin also called a "V-B group element") including an unshared pair of electrons or a functional group provided with a group 16 element including an unshared pair of electrons is adopted.

An example of the single source precursor is shown in the structural formula 1. In the formula, R"-E is the first chalcogen-element-containing organic compound (R" is the organic compound, and E is the chalcogen element). L is the first Lewis base. M' is the group 11 element. M" is the first group 13 element.

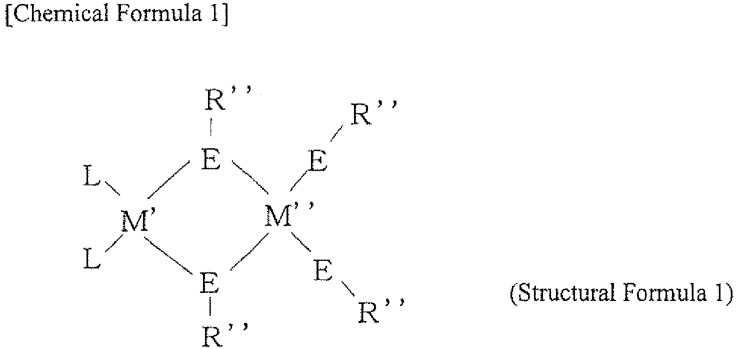

This single source precursor is made as follows. A method for making the single source precursor includes a step of making a first complex solution, a step of making a second complex solution, and a step of making a precipitate containing the single source precursor. In the following, each of the steps will be described in detail.

### <Step of Making a First Complex Solution>

Firstly, a first complex solution is made in which a first complex containing the first Lewis base and the group 11 element exists. As the first Lewis base, an organic compound containing a group 15 element such as P(C₆H₅)₃, As(C₆H₅)₃, or N(C₆H₅)₃ may be used. As a raw material of the group 11 element, an organic metal complex such as Cu(CH₃CN)₄·PF₆ may be mentioned. It is preferable that an organic ligand used for the organic metal complex has a lower basicity than that of the first Lewis base. As an organic solvent of the first complex solution, acetonitrile, acetone, methanol, ethanol, isopropanol, and the like, may be mentioned.

When the first Lewis base is defined as L, the organic metal complex of the group 11 element is defined as [M'R'₄]⁺(X')⁻, and the first complex is defined as [L₂M'R'₂]⁺(X')⁻, a reaction to form the above-mentioned first complex is expressed by the reaction formula 1. Here, M' represents a group 11 element, R' represents an arbitrary organic ligand, and (X')⁻ represents an arbitrary anion.

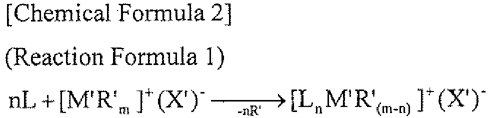

In a specific example of the reaction formula 1, for example, in a case where the first Lewis base L is P(C₆H₅)₃ and the organic metal complex [M'R'ₘ]⁺(X')⁻ of the group 11 element is Cu(CH₃CN)₄·PF₆, the first complex [LₙM'R'₍ₘ₋ₙ₎]⁺(X')⁻ is generated as

{P(C₆H₅)₃}₂Cu(CH₃CN)₂·PF₆.

### < Step of Making a Second Complex Solution >

A second complex solution is made in which a second complex containing the first chalcogen-element-containing organic compound and the first group 13 element exists. As the first chalcogen-element-containing organic compound, phenylselenol, diphenyldiselenide, or the like, may be used. As a raw material of the first group 13 element, a metal salt such as InCl₃ and GaCl₃ may be mentioned. As an organic solvent of the second complex solution, methanol, ethanol, propanol, and the like, may be mentioned.

When the chalcogen element is defined as E, a metal salt of the first chalcogen-element-containing organic compound is defined as A(ER"), a metal salt of the first group 13 element is defined as M"(X")₃, and the second complex is defined as A⁺[M"(ER")₄]⁻, a reaction to form the above-mentioned second complex is expressed by the reaction formula 2. Here, R" represents an organic compound, A represents an arbitrary cation, M" represents a first group 13 element, and X" represents an arbitrary anion. The metal salt A(ER") of the first chalcogen-element-containing organic compound is obtained by reacting a metal alkoxide such as NaOCH₃ with the first chalcogen-element-containing organic compound such as phenylselenol (HSeC₆H₅).

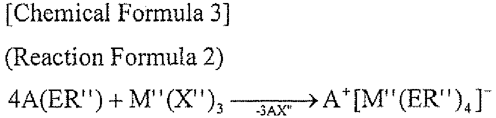

In a specific example of the reaction formula 2, for example, in a case where the metal salt A(ER") of the first chalcogen-element-containing organic compound is NaSeC₆H₅ and the metal salt M"(X")₃ of the first group 13 element is InCl₃ or GaCl₃, the second complex A⁺[M"(ER")₄]⁻ is generated as Na⁺[In(SeC₆H₅)₄]⁻ or Na⁺[Ga(SeC₆H₅)₄]⁻.

The first group 13 element contained in the second complex solution is not limited to only one kind, and a plurality of kinds of first group 13 elements may be contained. For example, both In and Ga may be contained in the second complex solution. Such a second complex solution is made by adopting, as a raw material of the second complex solution, a mixture of metal salts of a plurality of kinds of first group 13 elements. Alternatively, such a second complex solution may be made by making, with respect to each of first group 13 elements, a second complex solution containing one kind from the first group 13 elements and then mixing the second complex solutions.

### <Step of Making a Precipitate Containing a Single Source Precursor>

The first complex solution and the second complex solution made by the above-described manner are mixed, and thereby the first complex and the second complex are caused to react with each other, thus generating a precipitate containing a single source precursor that includes the group 11 element such as Cu, the first group 13 element such as In and Ga, and the chalcogen element such as Se. The reaction to form such a single source precursor [LnM'(ER")₂M"(ER")₂] is expressed by the reaction formula 3.

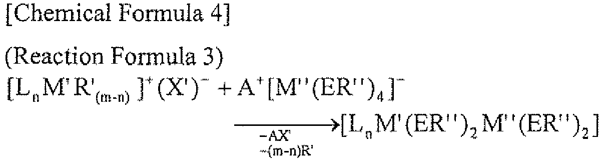

In a specific example of the reaction formula 3, in a case where the first complex is {P(C₆H₅)₃}₂Cu(CH₃CN)₂·PF₆ and the second complex is Na⁺[M"(SeC₆H₅)₄]⁻ (M" is In and/or Ga), the single source precursor is generated as {P(C₆H₅)₃}₂Cu(SeC₆H₅)₂M"(SeC₆H₅)₂.

The precipitate containing this single source precursor and a solution located above the precipitate are separated from each other, and a solution part is discharged and a precipitate part is dried, so that the precipitate containing the single source precursor is extracted.

In the reaction of the first complex with the second complex, the temperature is set at, for example, 0 to 30°C. A time period of this reaction is, for example, one to five hours. The precipitate caused by the reaction may be cleaned by means of centrifugation, filtration, or the like, in order to remove impurities such as Na and Cl therefrom.

### <<Step of Preparing a Second Compound>>

Next, the step of preparing the second compound will be shown. The second compound contains an organic ligand and a second group 13 element. The second group 13 element may be the same as or different from the first group 13 element mentioned above.

As the organic ligand of the second compound, one capable of coordination bonding with the second group 13 element and forming a complex is adopted. As such an organic ligand, for example, there may be mentioned an organic compound including an amino group, a phosphino group, a carboxyl group, and a carbonyl group, an organic compound including a group 16 element, and the like. Particularly, from the viewpoint of obtaining a good progress of chalcogenization and a reaction with the above-mentioned single source precursor to thereby successfully form the group 11-13-16 compound, the organic ligand may be a chalcogen-element-containing organic compound (hereinafter, a chalcogen-element-containing organic compound used as the organic ligand of the second compound will be also referred to as a second chalcogen-element-containing organic compound). In this manner, by using a chalcogen-element-containing organic compound as the organic ligand, the group 11-13-16 compound is successfully formed. This gives firmness to the first semiconductor layer 3, to make it difficult that damage such as cracking occurs in the first semiconductor layer 3 due to a thermal history involved in the use of the photoelectric conversion device 10. Such a second chalcogen-element-containing organic compound may be the same as or different from the first chalcogen-element-containing organic compound mentioned above.

In a case where the second compound contains the second chalcogen-element-containing organic compound and the second group 13 element, the second compound may be made, for example, as follows. Firstly, a raw material containing the second group 13 element and the second chalcogen-element-containing organic compound are dissolved in a solvent, to form the second compound having a complex form in which the second chalcogen-element-containing organic compound is coordinated to the second group 13 element. A solution including this second compound may be used as it is, to make a semiconductor layer forming solution which will be described later. Alternatively, a non-polar solvent or a low-polar solvent may be added to a solution including this second compound and then the second compound deposited may be extracted, to form a semiconductor layer forming solution, which will be described later, by using this extracted second compound. As the non-polar solvent or the low-polar solvent used for the deposition of the second compound, a non-polar solvent of hexane, heptane, carbon tetrachloride, benzene, or the like, may be used, or alternatively a low-polar solvent having a lower polarity than that of the solvent in which the second compound is dissolved may be used. In a case where the second compound is deposited in this manner, the second compound is washed and the removal of impurities is facilitated.

From the viewpoint of reducing remaining of an unnecessary component in the second compound, the second group 13 element in a single or alloy state may be directly dissolved in a mixed liquid of the second chalcogen-element-containing organic compound and a second Lewis base (hereinafter, the mixed liquid of the second chalcogen-element-containing organic compound and the second Lewis base will be also referred to as a mixed liquid M). This second Lewis base is for increasing coordinating power of the second chalcogen-element-containing organic compound, and may be the same as or different from the first Lewis base mentioned above. For example, In and/or Ga serving as the second group 13 element may be, as a single metal or as an alloy thereof, added to and dissolved in the mixed liquid M of phenylselenol serving as the chalcogen-element-containing organic compound and aniline serving as the second Lewis base. As a result, a second compound in which phenylselenol is coordinated to In and/or a second compound in which phenylselenol is coordinated to Ga is/are formed. This reduces remaining of an unnecessary counterion, as compared with using a metal salt as the raw material of the second group 13 element.

In the mixed liquid M, the second chalcogen-element-containing organic compound may be 1 to 250 mol% relative to the second Lewis base. This makes it easy to form chemical bonding between the second group 13 element and the second chalcogen-element-containing organic compound, thus successfully forming the second compound.

The second compound in a state of being formed in the mixed liquid M and dissolved in the mixed liquid M may be once extracted from the solution. In this case, a non-polar solvent or a low-polar solvent is added to the mixed liquid M containing the second compound, to thereby cause a deposition of the second compound.

In a case where aromatic amine such as pyridine or aniline is used as the second Lewis base of the mixed liquid M, aliphatic amine may be used as the low-polar solvent for causing a deposition of the second compound. Causing a deposition of the second compound by aliphatic amine in this manner reduces the amount of aromatic amine remaining in the deposit of the second compound. That is, aromatic amine bonded to the second compound in the mixed liquid M is substituted by aliphatic amine, and consequently aliphatic amine is more likely to remain in the deposit of the second compound than aromatic amine. Aliphatic amine more easily undergoes thermal decomposition than aromatic amine. Therefore, in a case of forming the first semiconductor layer 3 by using such a second compound, an unnecessary organic matter is thermally decomposed in an early stage in the formation of the first semiconductor layer 3. As a result, the group 11-13-16 compound is successfully generated, and thus the first semiconductor layer 3 is successfully formed. As such aliphatic amine, ethylenediamine, 2-methyl-1,3-propanediamine, and the like, may be mentioned.

### <<Step of Making a Semiconductor Layer Forming Solution>>

The semiconductor layer forming solution is made by dissolving, in the organic solvent, the precipitate of the single source precursor described above and the deposit of the second compound described above. Alternatively, the semiconductor layer forming solution may be made by dissolving the precipitate of the single source precursor described above in the solution containing the second compound described above. Mixing the single source precursor and the second compound in this manner makes it easy to adjust the molar ratio between the group 11 element and the group 13 element, and thus the first semiconductor layer 3 having a high photoelectric conversion efficiency is easily made. In the second compound, the organic ligand exists so as to surround the second group 13 element, to thereby increase the affinity for the single source precursor. Accordingly, in a case where the coating is formed by using such a semiconductor layer forming solution, the single source precursor and the second compound successfully approach each other, so that the single source precursor and the second compound are successfully dispersed without phase separation. As a result, when the coating is subjected to the heat treatment, the group 11 element, the group 13 element, and the group 16 element contained in the single source precursor are successfully reacted with the group 13 element contained in the second compound, thus successfully generating the group 11-13-16 compound.

In a case where the semiconductor layer forming solution is made by dissolving, in the organic solvent, the precipitate of the single source precursor and the deposit of the second compound, the organic solvent being adopted is the one that allows the single source precursor and the second compound to be dissolved therein. Examples of such an organic solvent include toluene, pyridine, xylene, and acetone.

In a case where the semiconductor layer forming solution is made by dissolving the precipitate of the single source precursor in the solution containing the second compound, the solution containing the second compound being adopted is the one that allows the single source precursor to be dissolved therein. In a case where the solution containing the second compound is the mixed liquid M having the second group 13 element dissolved therein, the basicity of the second Lewis base in the mixed liquid M may be lower than that of the first Lewis base of the single source precursor. This makes it more likely that, when the precipitate containing the single source precursor is dissolved in the mixed liquid M containing the second compound, the structure of the single source precursor is successfully maintained, and thus the semiconductor layer forming solution capable of successfully forming the group 11-13-16 compound is obtained.

In a case where the solution containing the second compound is the mixed liquid M having the second group 13 element dissolved therein, the boiling point of the second Lewis base in the mixed liquid M may be lower than that of the first Lewis base of the single source precursor. As a result, when the coating formed by using the semiconductor layer forming solution is subjected to the heat treatment and consequently becomes the first semiconductor layer 3 containing the group 11-13-16 compound, the second Lewis base is thermally decomposed earlier. This creates a state where the first Lewis base coordinated to the group 11 element of the single source precursor remains for a certain time period. In this time period, the first Lewis base coordinated to the group 11 element attracts the group 13 element, and thereby a reaction between the group 13 element and the group 11 element is likely to occur, thus promoting the formation of the first semiconductor layer 3 including the group 11-13-16 compound. A difference between the boiling point of the first Lewis base and the boiling point of the second Lewis base is, for example, 50°C or more, and furthermore 100°C or more. For example, in a case where the first Lewis base of the single source precursor is P(C₆H₅)₃, pyridine, aniline, or the like, may be adopted as the second Lewis base of the mixed liquid M.

The semiconductor layer forming solution made in the above-described manner is applied to a surface of the substrate 1 including the first electrodes 2, by using a spin coater, screen printing, dipping, spraying, a die coater, or the like, and then dried, to thereby form the coating. The drying may be performed in a reducing atmosphere, and a drying temperature may be 50 to 300°C, for example.

Then, the above-mentioned coating is subjected to the heat treatment, and the first semiconductor layer 3 having a thickness of 1 to 2.5 µm is made. The heat treatment may be performed in a reducing atmosphere, in order to prevent oxidation and successfully obtain the first semiconductor layer 3. The reducing atmosphere in the heat treatment may be any of a nitrogen atmosphere, a forming gas atmosphere, a hydrogen atmosphere, and the like. A heat treatment temperature may be, for example, 400°C to 600°C.

The above-mentioned coating is capable of causing a reaction of, as a raw material, the chalcogen element contained in the first chalcogen-element-containing organic compound (in a case where the second chalcogen-element-containing organic coumpound is also contained in the coating, a chalcogen element contained in the second chalcogen-element-containing organic compound is included, too), to form the first semiconductor layer 3 including the chalcogen element. Here, it may be also possible that a chalcogen element is separately dissolved in the semiconductor layer forming solution. Moreover, it may be also possible that a chalcogen element is contained in the atmosphere in which the coating is subjected to the heat treatment. Thereby, the chalcogen element, which is likely to be insufficient because of evaporation, can be sufficiently supplied, to facilitate successful formation of the first semiconductor layer 3 having a desired composition ratio.

By using the above-described semiconductor layer forming solution, the first semiconductor layer 3 having a desired composition ratio can be easily formed, which consequently improves the photoelectric conversion efficiency of a photoelectric conversion device including this first semiconductor layer 3.

In the photoelectric conversion device 10, the second semiconductor layer 4 having a conductive type different from that of the first semiconductor layer 3 is formed on the first semiconductor layer 3. The first semiconductor layer 3 and the second semiconductor layer 4 have different conductive types, one having the n-type and the other having the p-type, and they form a p-n junction. Alternatively, it may be possible that the first semiconductor layer 3 has the p-type and the second semiconductor layer 4 has the n-type, and vice versa. The p-n junction formed between the first semiconductor layer 3 and the second semiconductor layer 4 is not limited to a direct junction between the first semiconductor layer 3 and the second semiconductor layer 4. For example, another semiconductor layer having the same conductive type as that of the first semiconductor layer 3, or another semiconductor layer having the same conductive type as that of the second semiconductor layer 4, may be further provided therebetween. A pin junction may be also formed by providing an i-type semiconductor layer between the first semiconductor layer 3 and the second semiconductor layer 4.

The first semiconductor layer 3 and the second semiconductor layer 4 may form either a homo junction or a hetero junction. In a case of the hetero junction, CdS, ZnS, ZnO, In₂Se₃, In(OH,S), (Zn,In)(Se,OH), (Zn,Mg)O, and the like, may be mentioned as the second semiconductor layer 4. In this case, the second semiconductor layer 4 is formed with a thickness of 10 to 200 nm by, for example, a chemical bath deposition (CBD) process. Here, In(OH,S) means a compound mainly containing In, OH, and S. (Zn,In)(Se,OH) means a compound mainly containing Zn, In, Se, and OH. (Zn,Mg)O means a compound mainly containing Zn, Mg, and O.

The second electrode layer 5 is a transparent conductive film of 0.05 to 3µm comprised of ITO, ZnO, or the like. To improve a translucency and a conductivity, the second electrode layer 5 may be comprised of a semiconductor having the same conductive type as that of the second semiconductor layer 4. The second electrode layer 5 is formed by a sputtering process, a vapor-deposition process, a chemical vapor deposition (CVD) process, or the like. The second electrode layer 5 is a layer having a lower resistivity than that of the second semiconductor layer 4, and for extracting charges occurring in the first semiconductor layer 3. From the viewpoint of successfully extracting charges, the second electrode layer 5 may have a resistivity of less than 1 Ω·cm and a sheet resistance of 50Ω/□ or less.

To improve an absorption efficiency of the first semiconductor layer 3, the second electrode layer 5 may be transmissive for an absorbed light of the first semiconductor layer 3. From the viewpoint of improving a light transmissivity and successfully transferring a current caused by photoelectric conversion, the second electrode layer 5 may have a thickness of 0.05 to 0.5 µm. From the viewpoint of reducing a light reflection at an interface between the second electrode layer 5 and the second semiconductor layer 4, a difference in the refractive index between the second electrode layer 5 and the second semiconductor layer 4 may be small.

A light conversion module includes a plurality of the photoelectric conversion devices 10 being arranged and electrically connected to one another. To make it easy to connect adjacent photoelectric conversion devices 10 in series with each other, as shown in FIGS. 1 and 2, the photoelectric conversion device 10 comprises the third electrode layer 6 that is formed at the substrate 1 side of the first semiconductor layer 3 and that is spaced from the first electrode layer 2. The connecting conductor 7 formed in the first semiconductor layer 3 electrically connects the second electrode layer 5 and the third electrode layer 6 to each other.

The connecting conductor 7 may be formed in the same step as the step of forming the second electrode layer 5 and then integrated with the second electrode layer 5. This can simplify the steps, and additionally improve the reliability of electrical connection with the second electrode layer 5.

The connecting conductor 7 is formed so as to connect the second electrode layer 5 and the third electrode layer 6 to each other and so as to penetrate through each of the first semiconductor layers 3 of the adjacent photoelectric conversion devices 10. Such a configuration enables the photoelectric conversion to be successfully performed in each of the adjacent first semiconductor layers 3 and the current can be extracted by the series connection.

As shown in FIGS. 1 and 2, a collector electrode 8 may be formed on the second electrode layer 5. The collector electrode 8 is for reducing the electrical resistance of the second electrode layer 5. For example, as shown in FIG. 1, the collector electrode 8 is formed in a linear shape extending from one end of the photoelectric conversion device 10 to the connecting conductor 7. As a result, the current caused by the photoelectric conversion in the first semiconductor layer 3 is collected to the collector electrode 8 via the second electrode layer 5, and successfully conducted to the adjacent photoelectric conversion device 10 via the connecting conductor 7. Accordingly, since the collector electrode 8 is provided, even though the thickness of the second electrode layer 5 is reduced in order to improve the transmittance of light to the first semiconductor layer 3, the current caused in the first semiconductor layer 3 can be efficiency extracted. Consequently, the photoelectric conversion efficiency can be improved.

From the viewpoint of improving the transmittance of light to the first semiconductor layer 3 and providing a good conductivity, the collector electrode 8 may have a width of 50 to 400 µm. The collector electrode 8 may include a plurality of branched portions.

For example, a metal paste in which a powdered metal such as Ag is dispersed in a resin binder is printed in a pattern and cured to thereby form the collector electrode 8.

The collector electrode 8 may be provided so as to, in a plan view, reach an outer peripheral end of the first semiconductor layer 3. In this configuration an outer peripheral portion of the first semiconductor layer 3 is protected by the collector electrode 8. Accordingly, broken-away of the first semiconductor layer 3 in the outer peripheral portion is reduced, and the photoelectric conversion is successfully performed even in the outer peripheral portion of the first semiconductor layer 3. Moreover, a current caused in the outer peripheral portion of the first semiconductor layer 3 can be efficiency extracted by the collector electrode 8 that reaches the outer peripheral end. As a result, the photoelectric conversion efficiency of the photoelectric conversion device 10 is improved.

A method for manufacturing a semiconductor layer and a method for manufacturing a photoelectric conversion device according to one embodiment of the present invention were evaluated as follows.

### EXAMPLE 1

### <<Step of preparing a First Compound (Single Source Precursor)>>

### <Step of Making a First Complex Solution>

1 mmol of Cu(CH₃CN)₄·PF₆, as the organic metal complex of the group 11 element, and 2 mmol of P(C₆H₅)₃, as the first Lewis base, were dissolved in 10 ml of acetonitrile. This solution was stirred for five hours at room temperature by means of a magnetic stirrer, to thereby make the first complex solution (hereinafter, referred to as a first complex solution 1-1) containing the first complex.

### < Step of Making a Second Complex Solution>

Meanwhile, 4 mmol of NaOCH₃ and 4 mmol of HSeC₆H₅ were dissolved in 30 ml of methanol, and then InCl₃ and GaCl₃ were dissolved in a resulting solution so as to obtain 1 mmol in total. This solution was stirred for five hours at room temperature by means of a magnetic stirrer, to thereby make the second complex solution (hereinafter, referred to as a second complex solution 1-2) containing the second complex.

### <Step of Making a Precipitate Containing Single Source Precursor>

Then, the second complex solution 1-2 was dropped into the first complex solution 1-1 at a speed of 10 ml per one minute. As a result, it was observed that a white deposit was generated in the dropping. After the dropping ended, a resultant was stirred for one hour at room temperature by means of a magnetic stirrer. Then, it was observed that a deposit was precipitated in the solution.

This precipitate was extracted by a centrifugal separator. The precipitate thus extracted was dispersed in 50ml of methanol, and extracted again by a centrifugal separator. This operation was repeated twice. As a result, it was observed that the residual amount of Na in a finally extracted precipitate was 1 ppm or less.

This precipitate containing the single source precursor was dried in vacuum at room temperature, to remove the solvent. A composition of this precipitate was analyzed by using an optical emission spectroscopy (ICP). Table 1 shows a prepared composition ratio at the time of making the single source precursor and a composition ratio of the precipitate containing the single source precursor thus made.

**[Table 1]**

| Prepared Composition Ratio | | | | Composition Ratio of Precipitate | | | |
|---|---|---|---|---|---|---|---|
| Cu | In | Ga | Se | Cu | In | Ga | Se |
| 1 | 0.7 | 0.3 | 4 | 1.05 | 0.77 | 0.23 | 4.05 |

### <<Step of Making a Semiconductor Layer Forming Solution>>

Pyridine was added to this precipitate containing the single source precursor, and a plurality of solutions were made in which the precipitate occupied 50% by mass of the total amount. Then, indium acetylacetonate and/or gallium acetylacetonate, as the second compound, was/were added to and dissolved in each of these solutions so as to obtain the composition ratios shown in Table 2. Thus, a plurality of kinds of semiconductor layer forming solutions were made. The sample No. 4 was obtained by adding neither indium acetylacetonate nor gallium acetylacetonate.

**[Table 2]**

| Sample No. | Composition Ratio of Semiconductor Layer Forming Solution (In+Ga=1) | | | Photoelectric Conversion Efficiency (%) |
|---|---|---|---|---|
| | Cu | In | Ga | |
| 1 | 0.90 | 0.67 | 0.33 | 8.68 |
| 2 | 0.90 | 0.82 | 0.18 | 2.52 |
| 3 | 0.80 | 0.60 | 0.40 | 7.47 |
| 4 | 1.05 | 0.77 | 0.23 | 0.25 |

### <<Step of Making a Photoelectric Conversion Device>>

Each of these semiconductor layer forming solutions was applied onto the first electrode layer 2 comprised of Mo on the soda-lime glass substrate 1 by a doctor blade method, to thereby form a coating. To be specific, each of the semiconductor layer forming solutions was applied to the first electrode layer 2 by using a nitrogen gas as a carrier gas in a glove box, to thereby form an applied film. Then, the applied film was heated to be dried for five minutes at 110°C by a hot plate, thus forming a coating.

After the formation of the coating, the coating was subjected to a heat treatment in a hydrogen gas atmosphere. The heat treatment was performed under conditions that the temperature was rapidly raised up to 525°C in five minutes and kept at 525°C for one hour, and then naturally cooled. Thereby, the first semiconductor layer 3 comprised of a compound semiconductor thin film having a thickness of 1.5 µm was made.

Then, the sample having the above-described first semiconductor layer 3 formed thereon was immersed in an aqueous ammonia solution having cadmium acetate and thiourea dissolved therein. As a result, the second semiconductor layer 4 comprised of CdS having a thickness of 0.05 µm was formed on the first semiconductor layer 3. Additionally, on the second semiconductor layer 4, an Al-doped zinc oxide film (second electrode layer 5) was formed by a sputtering process. Finally, an aluminum electrode (extraction electrode) was formed by vapor deposition, thus making the photoelectric conversion device 10.

The photoelectric conversion efficiency of this photoelectric conversion device 10 was measured by using a fixed light solar simulator. Here, the photoelectric conversion efficiency was measured under conditions that the light radiation intensity to a light-receiving surface of the photoelectric conversion device 10 was 100mW/cm² and the air mass (AM) was 1.5. The photoelectric conversion efficiency indicates the percentage of solar light energy being converted into electrical energy in the photoelectric conversion device 10, and here, it is calculated by dividing the value of electrical energy outputted from the photoelectric conversion device 10 by the value of solar light energy incident on the photoelectric conversion device 10 and then multiplying a resulting value by 100.

Table 2 reveals that the molar ratio of Cu, In, and Ga of the first semiconductor layer 3 can be controlled by forming the first semiconductor layer 3 by using the semiconductor layer forming solution that contains the single source precursor and the second compound including the organic ligand, and thereby the photoelectric conversion efficiency of the photoelectric conversion device 10 can be improved.

### EXAMPLE 2

### <<Step of Preparing a First Compound (Single Source Precursor)>>

The precipitate containing the single source precursor made in the Example 1 was prepared.

### <<Step of Preparing a Second Compound>>

10 mmol of pyridine, as the second Lewis base, and 4 mmol of HSeC₆H₅, as the second chalcogen-element-containing organic compound, were mixed with each other, to make the mixed liquid M. Then, a metal indium and/or a metal gallium was/were dissolved in this mixed liquid M so as to obtain 4 mmol in total. In this manner, a plurality of kinds of solutions each containing the second compound were made.

### <<Step of Making a Semiconductor Layer Forming Solution>>

The precipitate containing the single source precursor described above was dissolved in each of the plurality of kinds of solutions each containing the second compound. Thus, a plurality of kinds of semiconductor layer forming solutions having the composition ratios as shown in Table 3 were made. The sample No. 8 was obtained by dissolving the above-mentioned precipitate not in the solution containing the second compound but in the mixed liquid M.

**[Table 3]**

| Sample No. | Composition Ratio of Semiconductor Layer Forming Solution (In+Ga=1) | | | Photoelectric Conversion Efficiency (%) |
|---|---|---|---|---|
| | Cu | In | Ga | |
| 5 | 0.85 | 0.81 | 0.19 | 2.58 |
| 6 | 0.90 | 0.80 | 0.20 | 3.89 |
| 7 | 0.95 | 0.79 | 0.21 | 4.95 |
| 8 | 1.05 | 0.77 | 0.23 | 0.25 |

### <<Step of Making a Photoelectric Conversion Device>>

The photoelectric conversion devices 10 were made by using these semiconductor layer forming solutions. Conditions for making the photoelectric conversion devices were the same as those of the Example 1.

The photoelectric conversion efficiency of each of the photoelectric conversion devices 10 was measured by using a fixed light solar simulator. The measurement conditions were the same as those of the Example 1.

Table 3 reveals that the molar ratio of Cu, In, and Ga of the first semiconductor layer 3 can be controlled by forming the first semiconductor layer 3 by using the semiconductor layer forming solution comprised of the single source precursor and the solution including the second compound, and thereby the photoelectric conversion efficiency of the photoelectric conversion device 10 can be improved.

### EXAMPLE 3

### <<Step of Preparing a First Compound (Single Source Precursor)>>

By the same method as in the Example 1, four batches of the precipitates each containing the single source precursors were made. With respect to them, Table 4 shows prepared composition ratios at the time of making the single source precursors and composition ratios of the precipitates each containing the single source precursor thus made (the samples were made under the same conditions, and the difference in the composition ratio among the resulting precipitates indicates experimental variations).

**[Table 4]**

| Sample No. | Prepared Composition Ratio | | | | Composition Ratio of Precipitate | | | |
|---|---|---|---|---|---|---|---|---|
| | Cu | In | Ga | Se | Cu | In | Ga | Se |
| 9 | 1 | 0.7 | 0.3 | 4 | 1.01 | 0.78 | 0.22 | 4.01 |
| 10 | 1 | 0.7 | 0.3 | 4 | 1.04 | 0.80 | 0.20 | 4.08 |
| 11 | 1 | 0.7 | 0.3 | 4 | 1.04 | 0.80 | 0.20 | 4.08 |
| 12 | 1 | 0.7 | 0.3 | 4 | 1.05 | 0.77 | 0.23 | 4.05 |

### <<Step of Preparing a Second Compound>>

50 mmol of aniline, as the second Lewis base, and 60 mmol of HSeC₆H₅, as the second chalcogen-element-containing organic compound, were mixed with each other, to make the mixed liquid M. Then, a metal indium and/or a metal gallium was/were dissolved in this mixed liquid M so as to obtain 10 mmol in total. Thereby, a plurality of kinds of solutions each containing the second compound were made. Then, hexane was added to each of these solutions each containing the second compound and then stirred, so that a deposit of the second compound was obtained. This deposit of the second compound was extracted by a centrifugal separator. This extracted deposit was dispersed in 50 ml of hexane, and extracted again by a centrifugal separator. This operation was repeated twice.

### <<Step of Making a Semiconductor Layer Forming Solution>>

This second compound was mixed with the above-mentioned precipitates each containing the single source precursor (sample Nos. 9 to 12) while being adjusted so as to obtain the composition ratios as shown in Table 5. Then, pyridine was added to them. Thereby, the semiconductor layer forming solutions were made in which the second compound and the precipitate of the single source precursor occupied 45% by mass of the total amount. The sample No. 12 was obtained by adding no second compound.

**[Table 5]**

| Sample No. | Composition Ratio of Semiconductor Layer Forming Solution (In+Ga=1) | | | Photoelectric Conversion Efficiency (%) |
|---|---|---|---|---|
| | Cu | In | Ga | |
| 9 | 0.90 | 0.70 | 0.30 | 8.33 |
| 10 | 0.90 | 0.70 | 0.30 | 8.07 |
| 11 | 0.90 | 0.70 | 0.30 | 8.45 |
| 12 | 1.05 | 0.77 | 0.23 | 0.25 |

### <<Step of Making a Photoelectric Conversion Device>>

The photoelectric conversion devices 10 were made by using these semiconductor layer forming solutions. Conditions for making the photoelectric conversion devices were the same as those of the Example 1.

The photoelectric conversion efficiency of each of the photoelectric conversion devices 10 was measured by using a fixed light solar simulator. The measurement conditions were the same as those of the Example 1.

Table 5 reveals that the molar ratio of Cu, In, and Ga of the first semiconductor layer 3 can be controlled by forming the first semiconductor layer 3 by using the semiconductor layer forming solution that contains the single source precursor and the second compound including the second chalcogen-element-containing organic compound, and thereby the photoelectric conversion efficiency of the photoelectric conversion device 10 can be improved.

### EXAMPLE 4

### <<Step of Preparing a First Compound (Single Source Precursor)>>

By the same method as in the Example 1, four batches of the the precipitates each containing the single source precursors were made. With respect to them, Table 6 shows prepared composition ratios at the time of making the single source precursors and composition ratios of the precipitates each containing the single source precursor thus made.

**[Table 6]**

| Sample No. | Prepared Composition Ratio | | | | Composition Ratio of Precipitate | | | |
|---|---|---|---|---|---|---|---|---|
| | Cu | In | Ga | Se | Cu | In | Ga | Se |
| 13 | 1 | 0.7 | 0.3 | 4 | 1.04 | 0.77 | 0.23 | 4.05 |
| 14 | 1 | 0.7 | 0.3 | 4 | 1.05 | 0.79 | 0.21 | 4.05 |
| 15 | 1 | 0.7 | 0.3 | 4 | 1.05 | 0.80 | 0.20 | 4.09 |
| 16 | 1 | 0.7 | 0.3 | 4 | 1.05 | 0.77 | 0.23 | 4.05 |

### <<Step of Preparing a Second Compound>>

50 mmol of aniline, as the aromatic amine, and 60 mmol of HSeC₆H₅, as the second chalcogen-element-containing organic compound, were mixed with each other, to make the mixed liquid M. Then, a metal indium and/or a metal gallium was/were dissolved in this mixed liquid M so as to obtain 10 mmol in total. Thereby, a plurality of kinds of solutions each containing the second compound were made. Then, ethylenediamine was added to each of these solutions each containing the second compound and then stirred, so that a deposit of the second compound was obtained. This deposit of the second compound was extracted by a centrifugal separator. This extracted deposit was dispersed in 50 ml of ethylenediamine, and extracted again by a centrifugal separator. This operation was repeated twice.

### <<Step of Making a Semiconductor Layer Forming Solution>>

This second compound was mixed with the above-mentioned precipitates each containing the single source precursor (sample Nos. 13 to 16) while being adjusted so as to obtain the composition ratios as shown in Table 7. Then, pyridine was added to them. Thereby, the semiconductor layer forming solutions were made in which the second compound and the precipitate of the single source precursor occupied 45% by mass of the total amount. The sample No. 16 was obtained by adding no second compound.

**[Table 7]**

| Sample No. | Composition Ratio of Semiconductor Layer Forming Solution (In+Ga=1) | | | Photoelectric Conversion Efficiency (%) |
|---|---|---|---|---|
| | Cu | In | Ga | |
| 13 | 0.84 | 0.62 | 0.38 | 5.26 |
| 14 | 0.90 | 0.70 | 0.30 | 4.95 |
| 15 | 0.90 | 0.71 | 0.29 | 4.77 |
| 16 | 1.05 | 0.77 | 0.23 | 0.25 |

### <<Step of Making a Photoelectric Conversion Device>>

The photoelectric conversion devices 10 were made by using these semiconductor layer forming solutions. Conditions for making the photoelectric conversion devices were the same as those of the Example 1.

The photoelectric conversion efficiency of each of the photoelectric conversion devices 10 was measured by using a fixed light solar simulator. The measurement conditions were the same as those of the Example 1.

Table 7 reveals that the molar ratio of Cu, In, and Ga of the first semiconductor layer 3 can be arbitrarily controlled by forming the first semiconductor layer 3 by using the semiconductor layer forming solution that contains the single source precursor and the second compound including the second chalcogen-element-containing organic compound, and thereby the photoelectric conversion efficiency of the photoelectric conversion device 10 can be improved.

The present invention is not limited to the embodiment described above, and various modifications can be made without departing from the scope of the present invention as defined in the claims.

### DESCRIPTION OF THE REFERENCE NUMERALS

1: substrate
2: first electrode layer
3: first semiconductor layer
4: second semiconductor layer
5: second electrode layer
6: third electrode layer
7: connecting conductor
8: collector electrode
10: photoelectric conversion device

## Claims

1. A method for manufacturing a semiconductor layer, the method comprising:
preparing a first compound that contains a first chalcogen-element-containing organic compound, a first Lewis base, a group 11 element, and a first group 13 element;
preparing a second compound that contains an organic ligand and a second group 13 element, wherein chalcogen element means S, Se or Te;
making a semiconductor layer forming solution that contains the first compound, the second compound, and an organic solvent; and
forming a semiconductor layer that contains a group 11-13-16 compound by using the semiconductor layer forming solution,
**characterized in that** the organic ligand is a second chalcogen-element-containing organic compound.

2. The method for manufacturing a semiconductor layer according to claim 1, wherein
the preparing of the second compound comprises making a solution containing the second compound by adding the second group 13 element to a mixed liquid including a second Lewis base and the second chalcogen-element-containing organic compound, and
the making of the semiconductor layer forming solution comprises dissolving the first compound in the solution containing the second compound.

3. The method for manufacturing a semiconductor layer according to claim 2, wherein
a Lewis base having a basicity lower than that of the first Lewis base is adopted as the second Lewis base.

4. The method for manufacturing a semiconductor layer according to claim 2, wherein
a Lewis base having a boiling point lower than that of the first Lewis base is adopted as the second Lewis base.

5. The method for manufacturing a semiconductor layer according to claim 1, wherein
the preparing of the second compound comprises adding a non-polar solvent or a low-polar solvent to a solution including a second Lewis base, the second chalcogen-element-containing organic compound, and the second group 13 element, and then extracting a deposit of the second compound.

6. The method for manufacturing a semiconductor layer according to claim 5, wherein
an aromatic amine is adopted as the second Lewis base, and an aliphatic amine is adopted as the low-polar solvent.

7. The method for manufacturing a semiconductor layer according to any one of claims 1 to 5, wherein
the forming of a semiconductor layer comprises forming a coating by appling the semiconductor layer forming solution to a substrate, and heating the coating.

8. A method for manufacturing a photoelectric conversion device, the method comprising:
forming a first semiconductor layer by the method for manufacturing a semiconductor layer according to any one of claims 1 to 7; and
forming a second semiconductor layer that is electrically connected to the first semiconductor layer and whose conductivity type is different from that of the first semiconductor layer.

9. A semiconductor layer forming solution comprising:
a first compound that contains a first chalcogen-element-containing organic compound, a first Lewis base, a group 11 element, and a first group 13 element;
a second compound that contains an organic ligand and a second group 13 element; and
an organic solvent, wherein chalcogen element means S, Se or Te;
**characterized in that** the organic ligand is a second chalcogen-element-containing organic compound.

## Patentansprüche

1. Ein Verfahren zum Herstellen einer Halbleiterschicht, wobei das Verfahren aufweist:
Bereitstellen einer ersten Verbindung, die eine erste Chalkogen-Element-haltige organische Verbindung, eine erste Lewis-Base, ein Gruppe-11-Element und ein erstes Gruppe-13-Element enthält,
Bereitstellen einer zweiten Verbindung, die einen organischen Liganden und ein zweites Gruppe-13-Element enthält, wobei Chalkogen-Element S, Se oder Te bedeutet,
Erzeugen einer Halbleiterschicht-Bildungslösung, die die erste Verbindung, die zweite Verbindung und ein organisches Lösungsmittel enthält, und
Formen einer Halbleiterschicht, die eine Gruppe-11-13-16-Verbindung enthält, unter Verwendung der Halbleiterschicht-Bildungslösung,
**dadurch gekennzeichnet, dass** der organische Ligand eine zweite Chalkogen-Element-haltige organische Verbindung ist.

2. Das Verfahren zum Herstellen einer Halbleiterschicht gemäß Anspruch 1, wobei
das Bereitstellen der zweiten Verbindung das Erzeugen einer Lösung aufweist, die die zweite Verbindung enthält, durch Hinzufügen des zweiten Gruppe-13-Elements zu einem Flüssiggemisch, das eine zweite Lewis-Base und die zweite Chalkogen-Element-haltige organische Verbindung enthält, und
das Erzeugen der Halbleiterschicht-Bildungslösung das Lösen der ersten Verbindung in der die zweite Verbindung enthaltenden Lösung aufweist.

3. Das Verfahren zum Herstellen einer Halbleiterschicht gemäß Anspruch 2, wobei
eine Lewis-Base mit einer Basizität, die niedriger als diejenige der ersten Lewis-Base ist, als zweite Lewis-Base verwendet wird.

4. Das Verfahren zum Herstellen einer Halbleiterschicht gemäß Anspruch 2, wobei
eine Lewis-Base, die einen Siedepunkt hat, der niedriger als derjenige der ersten Lewis-Base ist, als die zweite Lewis-Base verwendet wird.

5. Das Verfahren zum Herstellen einer Halbleiterschicht gemäß Anspruch 1, wobei
das Bereitstellen der zweiten Verbindung das Hinzufügen eines unpolaren Lösungsmittels oder eines niedrigpolaren Lösungsmittels zu einer Lösung, die eine zweite Lewis-Base, die zweite Chalkogen-Element-haltige organische Verbindung und das zweite Gruppe-13-Element enthält, und anschließend das Extrahieren einer Ablagerung der zweiten Verbindung aufweist.

6. Das Verfahren zum Herstellen einer Halbleiterschicht gemäß Anspruch 5, wobei
ein aromatisches Amin als zweite Lewis-Base verwendet wird und ein aliphatisches Amin als das niedrigpolare Lösungsmittel verwendet wird.

7. Das Verfahren zum Herstellen einer Halbleiterschicht gemäß irgendeinem der Ansprüche 1 bis 5, wobei
das Bilden einer Halbleiterschicht das Bilden einer Beschichtung durch Aufbringen der Halbleiterschicht-Bildungslösung auf ein Substrat und das Erhitzen der Beschichtung aufweist.

8. Ein Verfahren zum Herstellen einer photoelektrischen Umwandlungsvorrichtung, wobei das Verfahren aufweist:
Bilden einer ersten Halbleiterschicht durch das Verfahren zum Herstellen einer Halbleiterschicht gemäß irgendeinem der Ansprüche 1 bis 7, und
Bilden einer zweiten Halbleiterschicht, die elektrisch mit der ersten Halbleiterschicht verbunden ist und deren Leitfähigkeitstyp sich von demjenigen der ersten Halbleiterschicht unterscheidet.

9. Eine Halbleiterschicht-Bildungslösung, aufweisend:
eine erste Verbindung, die eine erste Chalkogen-Element-haltige organische Verbindung, eine erste Lewis-Base, ein Gruppe-11-Element und ein erstes Gruppe-13-Element enthält,
eine zweite Verbindung, die einen organischen Liganden und ein zweites Gruppe-13-Element enthält, und
ein organisches Lösungsmittel, wobei Chalkogen-Element S, Se oder Te bedeutet,
**dadurch gekennzeichnet, dass** der organische Ligand eine zweite Chalkogen-Element-haltige organische Verbindung ist.

## Revendications

1. Un procédé de fabrication d'une couche de semi-conducteur, le procédé comportant les étapes suivantes consistant à :
préparer un premier composé qui contient un premier composé organique contenant un élément chalcogène, une première base de Lewis, un élément du groupe 11 et un premier élément du groupe 13 ;
préparer un deuxième composé qui contient un ligand organique et un deuxième élément du groupe 13, dans lequel élément chalcogène signifie S, Se ou Te ;
faire une solution pour former une couche de semi-conducteur qui contient le premier composé, le deuxième composé et un solvant organique, et
former une couche de semi-conducteur qui contient un composé de groupe 11-13-16 en utilisant la solution pour former une couche de semi-conducteur,
**caractérisé en ce que** le ligand organique est un deuxième composé organique contenant un élément chalcogène.

2. Le procédé de fabrication d'une couche de semi-conducteur selon la revendication 1, dans lequel
préparer le deuxième composé comprend faire une solution contenant le deuxième composé en ajoutant le deuxième élément du groupe 13 à un liquide mélangé comprenant une deuxième base de Lewis et le deuxième composé organique contenant un élément chalcogène, et
faire la solution pour former une couche de semi-conducteur comprend dissoudre le premier composé dans la solution contenant le deuxième composé.

3. Le procédé de fabrication d'une couche de semi-conducteur selon la revendication 2, dans lequel
une base de Lewis ayant une basicité inférieure à celle de la première base de Lewis est adoptée en tant que deuxième base de Lewis.

4. Le procédé de fabrication d'une couche de semi-conducteur selon la revendication 2, dans lequel
une base de Lewis ayant un point d'ébullition inférieur à celui de la première base de Lewis est adoptée en tant que deuxième base de Lewis.

5. Le procédé de fabrication d'une couche de semi-conducteur selon la revendication 1, dans lequel
préparer le deuxième composé comprend ajouter un solvant non-polaire ou un solvant de faible polarité à une solution comprenant une deuxième base de Lewis, le deuxième composé organique contenant un élément chalcogène et le deuxième élément du groupe 13, et puis extraire un dépôt du deuxième composé.

6. Le procédé de fabrication d'une couche de semi-conducteur selon la revendication 5, dans lequel
une amine aromatique est adoptée en tant que deuxième base de Lewis et une amine aliphatique est adoptée en tant que solvant de polarité faible.

7. Le procédé de fabrication d'une couche de semi-conducteur selon l'une quelconque des revendications 1 à 5, dans lequel
former une couche de semi-conducteur comprend former un revêtement en appliquant la solution pour former une couche de semi-conducteur à un substrat et chauffer le revêtement.

8. Un procédé de fabrication d'un dispositif de conversion photoélectrique, le procédé comportant :
former une première couche de semi-conducteur moyennant le procédé de fabrication d'une couche de semi-conducteur selon l'une quelconque des revendications 1 à 7, et
former une deuxième couche de semi-conducteur qui est reliée électriquement à la première couche de semi-conducteur et dont le type de conductivité est différent de celui de la première couche de semi-conducteur.

9. Une solution pour former une couche de semi-conducteur, comprenant :
un premier composé qui contient un premier composé organique contenant un élément chalcogène, une première base de Lewis, un élément du groupe 11 et un premier élément du groupe 13 ;
un deuxième composé qui contient un ligand organique et un deuxième élément du groupe 13 ; et
un solvant organique, dans lequel élément chalcogène signifie S, Se ou Te
**caractérisée en ce que** le ligand organique est un deuxième composé organique contenant un élément chalcogène.
